# EUROPEAN PATENT SPECIFICATION

(11) **EP 0 208 316 B1**
(45) Date of publication and mention of the grant of the patent: **13.01.1993**
(21) Application number: 86109436.5
(22) Date of filing: 10.07.1986
(51) Int. Cl.: G11C 11/406, G11C 11/407

(54) **Dynamic memory device**
Dynamische Speicheranordnung
Dispositif de mémoire dynamique

(30) Priority: 10.07.1985 JP 150094/85
(43) Date of publication of application: 14.01.1987
(73) Proprietor: FUJITSU LIMITED, Tokyo (JP)
(72) Inventor: Takemae, Yoshihiro Fujitsu Ltd Patent Department, Nakahara-ku Kawasaki-shi Kanagawa 211 (JP); Nakano, Masao Fujitsu Ltd Patent Department, Nakahara-ku Kawasaki-shi Kanagawa 211 (JP); Sato, Kimiaki Fujitsu Ltd Patent Department, Nakahara-ku Kawasaki-shi Kanagawa 211 (JP); Kodama, Nobumi Fujitsu Ltd Patent Department, Nakahara-ku Kawasaki-shi Kanagawa 211 (JP)
(74) Representative: Sunderland, James Harry

(56) References cited:
- GB-A- 2 116 338
- US-A- 3 729 722
- US-A- 4 334 295
- US-A- 4 653 030

## Description

This invention relates to a dynamic memory device.

Of the various memory devices used for various kinds of computers or data processing devices, dynamic memory devices, especially semiconductor dynamic memory devices, are probably most widely used because of their low cost and stable operation. One factor which could improve the speed of operation of computers or data processing systems would be a reduction in memory device access time.

A dynamic memory cell of a memory device must be refreshed periodically in order that it retain its data. Such refreshing has been carried out by selecting word lines by means of an external circuit, in a manner similar to that used to read data in the memory device. However, such an external refreshing method is not so easy to carry out in practice especially for a large-scale memory device.

It has been proposed that refreshing should be accomplished by an internal refreshing method whereby memory cells corresponding to addresses generated by an internal address counter are refreshed.

In such a case, the memory device has to recognize or distinguish between a state in which it is required to refresh stored data and a state in which it is required to access data stored in memory cells of the memory device. This has been accomplished by discriminating the falling edges of a column address stroke (strobe) bar signal (CAS bar signal, denoted by C̅A̅S̅) and a row address stroke (strobe) bar signal (RAS bar signal, denoted by R̅A̅S̅). If the falling edge of the C̅A̅S̅ signal is detected earlier than that of the R̅A̅S̅ signal, the memory device determines that refreshing should be carried out, but if the falling edge of the C̅A̅S̅ signal is detected after the falling edge of the R̅A̅S̅ signal, the memory device determines that it should access stored data.

Normally, a dynamic memory device is involved in operations for sending or receiving data as between its memory cells and external circuits. Hence, reading and writing of the memory are its normal operations. Such operations (usually called access operations) are controlled by C̅A̅S̅ and R̅A̅S̅ signals. However, during such operations, stored data is to be refreshed. Switching of operations (between access operations and refresh operations)is effected by advancing or delaying the falling edge of the C̅A̅S̅ or R̅A̅S̅ signals. These control signals are supplied to the memory device from external circuits. When the memory device is fabricated as an IC (integrated circuit) and packed in a single package, these signals are supplied to respective contact pins of the IC.

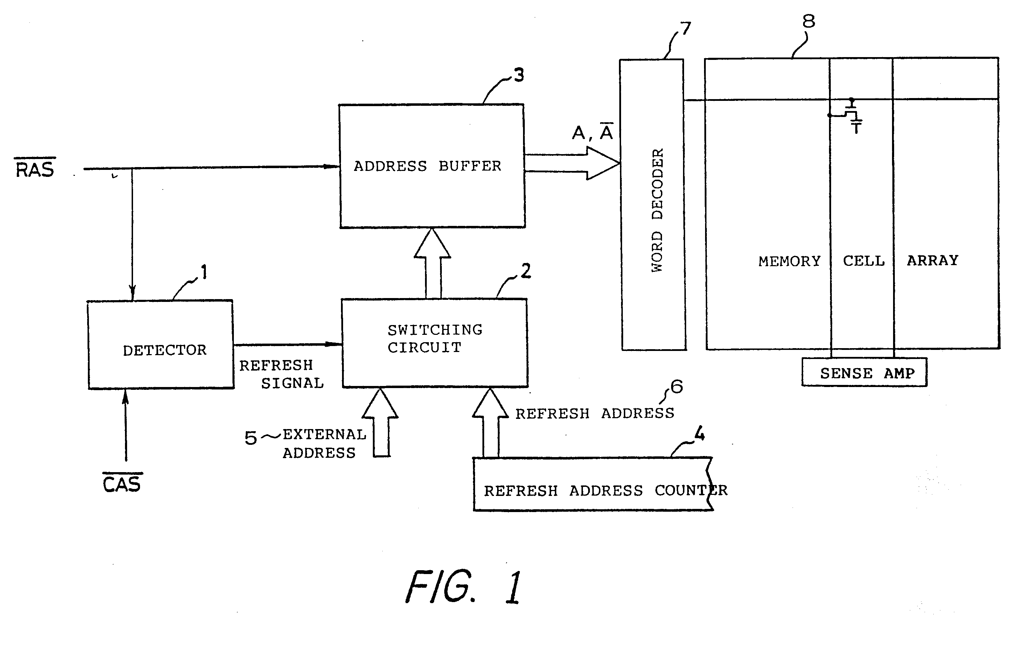

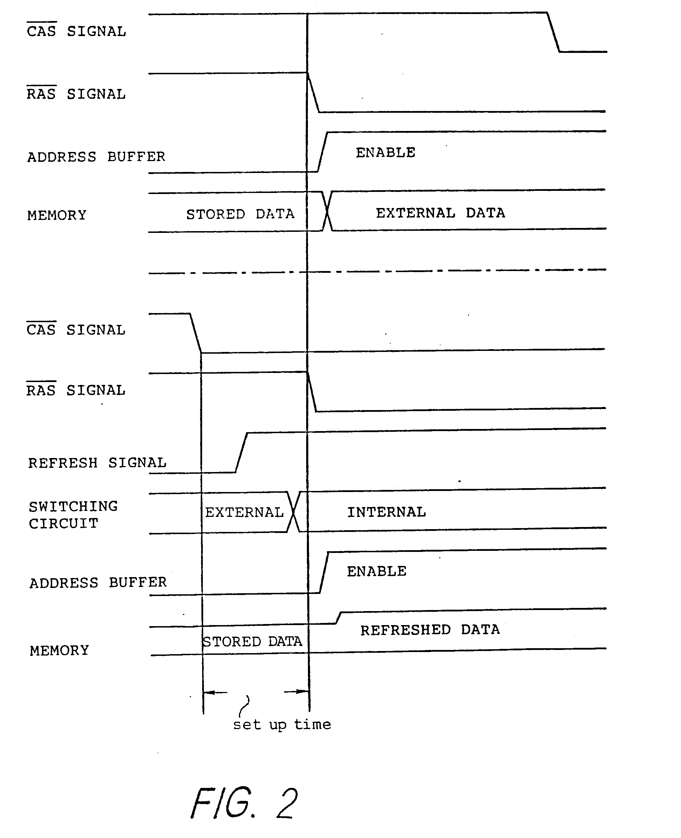

Refreshing and access operations of a previously proposed memory device will be described briefly with reference to Figs. 1 and 2.

Fig. 1 is a schematic block diagram for assistance in explaining refresh or rewrite operations of a previously proposed dynamic memory device.

In Fig. 1, 1 is a detector for detecting the falling edges of C̅A̅S̅ and R̅A̅S̅ signals, and for discriminating which falling edge occurs earlier. This detector 1 sends a refresh signal to a switching circuit 2 when it is detected that the falling edge of the C̅A̅S̅ signal is earlier than that of the R̅A̅S̅ signal. Therefore, the detector is called a C̅A̅S̅ before R̅A̅S̅ detector.

To the switching circuit 2 are supplied an external address 5 and a refresh address 6, which latter is generated by a refresh address counter 4. The external address 5 is the address of a memory cell into which new data is to be written (or rewritten). The external address 5 is supplied through a contact pin or pins of the memory IC. Normally, the switching circuit 2 is switched to the external address side, so as to take in a new external address signal 5 supplied from external circuitry and to send the external address to an address buffer 3. However, when the switching circuit 2 receives the refresh signal, it switches to the refresh address counter side, so as to send a refresh address 6 to the address buffer 3.

The address buffer 3 latches address signals sent from the switching circuit 2, and sends them successively to a word decoder 7. The word decoder selects word lines corresponding to address signals, and accesses data in corresponding memory cells in a memory cell array 8. Since processes such as decoding and storing data and reading out data are not directly relevant to the present invention, further description thereof is omitted.

In a normal access operation, the C̅A̅S̅ signal is controlled so as always to be at a high level H when the R̅A̅S̅ signal is at a high level H, and only after the R̅A̅S̅ signal takes a low level L, does C̅A̅S̅ take a low level. Therefore, normally an external address is taken in, so data is stored in or read out from memory cells. However, when the falling edge of the C̅A̅S̅ signal is shifted so that C̅A̅S̅ goes down earlier than R̅A̅S̅, a refresh signal is sent from the detector 1, and the switching circuit 2 sends a refresh address to the address buffer 3, so stored data is refreshed.

Fig. 2 is a time chart schematically illustrating operational timing of various signals and operations in relation to the circuit of Fig. 1. The portion of Fig. 2 above the chain line illustrates time relationships for normal operation, namely when an external address is taken in, whilst the portion of Fig. 2 below the chain line illustrates time relationships for refresh operation.

In a normal access operation, the C̅A̅S̅ signal is at an H level, so the detector 1 does not send out a refresh signal, and the switching circuit 2 is switched to the external address side. When the R̅A̅S̅ signal goes down to an L level it is detected by the address buffer 3, and the address buffer 3 is brought into an enabled state. Then, the external address is latched into the address buffer 3, and successively sent out to a word decoder 7, as address signal A and A̅. So, data is accessed in the memory array 8. This means that stored data is accessed.

At a time of refreshing (see the portion of Fig. 2 below the chain line), timing of the C̅A̅S̅ signal is shifted so that C̅A̅S̅ becomes L level before the R̅A̅S̅ signal is pulled down to L level. Such shifting is achieved by count shifting of a clock pulse or by using a delay circuit. This is detected by the detector 1 (which is a C̅A̅S̅ before R̅A̅S̅ detector), which sends a refresh signal to the switching circuit 2. The switching circuit 2 switches the flow of data from external to internal, that is from external addresses to refresh addresses. Then, the R̅A̅S̅ signal is pulled down, and the address buffer 3 is enabled, so a refresh address is sent to the word decoder and stored data is refreshed.

As has been described above and as can be seen in Fig. 2, in order to start up the refreshing process in the arrangement of Fig. 1, it is necessary to pull down the C̅A̅S̅ signal, before the R̅A̅S̅ signal goes down to an L level. The time between the falling edge of the C̅A̅S̅ signal and that of the R̅A̅S̅ signal is called set-up time. The set-up time should be as short as possible in order that the access time of the memory device is short. Most of the set-up time is consumed by the detection of C̅A̅S̅ before R̅A̅S̅, sending a refresh signal, receiving the refresh signal and switching the switching circuit. All these processes occur sequentially, so it is impossible to reduce the set-up time by more than (to less than) approximately 20 to 30 n.sec. using present state-of-the-art technology.

Moreover, in semiconductor dynamic memory devices, normal operations for taking in external data usually begin with the detection of the falling edge of an R̅A̅S̅ signal. So, most memory systems using such memory devices are designed to begin operation taking the falling edge of an R̅A̅S̅ signal as a starting signal. Therefore, a rather complicated process is necessary in order to make a C̅A̅S̅ signal achieve L level before an R̅A̅S̅ signal reaches L level, without disturbing the operation of the circuitries of the memory systems.

On the other hand, total access time of a memory device is typically approximately 100 n.sec. So, a set-up time of 20 to 30 n.sec. accounts for a major portion of the total access time. Therefore, reduction of set-up time is an important problem in the context of reducing access time of a memory system.

US-A-4 334 295 discloses a semiconductor dynamic memory device, read/write and refreshing operations of which are controlled in dependence upon R̅A̅S̅ and C̅A̅S̅ signals supplied from external circuitry, comprising:-
a memory cell array for storing data;
a word decoder for decoding address signals supplied thereto and for selecting word lines of the memory array; and
a refresh address counter for generating refresh address signals.

According to the present invention there is provided a semiconductor dynamic memory device, read/write and refreshing operations of which are controlled in dependence upon R̅A̅S̅ and C̅A̅S̅ signals supplied from external circuitry, comprising:-
a memory cell array for storing data;
a word decoder for decoding address signals supplied thereto and for selecting word lines of the memory array; and
a refresh address counter for generating refresh address signals;
characterised in that the memory device further comprises:-
a C̅A̅S̅ before R̅A̅S̅ detector, operable to detect falling edges of the C̅A̅S̅ and R̅A̅S̅ signals applied to the memory device, and to provide an external address driving signal (ADE) when it detects that a falling edge of the R̅A̅S̅ signal precedes a falling edge of the C̅A̅S̅ signal, and to provide a refresh address driving signal (ADI) when it detects that a falling edge of the C̅A̅S̅ signal precedes a falling edge of the R̅A̅S̅ signal;
external address buffer means for latching, in response to a falling edge of the R̅A̅S̅ signal, an external address sent to the dynamic memory device from an external circuit, and for sending that address to said word decoder when said external address buffer means receives said external address driving signal (ADE); and
refresh address buffer means for latching, in response to a falling edge of the R̅A̅S̅ signal, a refresh address generated by the refresh address counter and sending that refresh address to said word decoder when said refresh address buffer means receives said refresh address driving signal (ADI).

An embodiment of the present invention can provide for a reduction in the access time of a memory system using a semiconductor dynamic memory device, and can offer improvement in relation to the operation cycle time of computers or data processors employing dynamic memory devices.

An embodiment of the present invention can provide for a reduction in set-up time of a dynamic memory device.

A dynamic memory device embodying the present invention provides that circuitries therein do not operate in sequence, but rather that those circuitries operate in parallel.

In an embodiment of the present invention two address buffers are provided. One of these two address buffer memories is exclusively used to latch external addresses. The other of these two address buffer memories is exclusively used to latch refresh addresses. The two address buffer memories are called the external address buffer and refresh address buffer respectively.

Each of these address buffers comprises a preamplifier and a driver. To the preamplifier of the external address buffer are supplied external address signals, and to the preamplifier of the refresh address buffer are supplied refresh address signals. These preamplifiers are enabled by the falling edge of a R̅A̅S̅ signal, but their output drivers are still not enabled.

Normally, as mentioned above, the falling edge of a C̅A̅S̅ signal appears after the R̅A̅S̅ signal has achieved low level L. So, a C̅A̅S̅ before R̅A̅S̅ detector discriminates this, and sends out an eternal address driving signal (ADE) to the driver of the external address buffer and enables that driver. Therefore, normally, an external address signal is sent out from the driver of the external address buffer to the address decoder, and a read-out operation is performed to write external data into a memory cell of a dynamic memory device.

If the C̅A̅S̅ before R̅A̅S̅ detector detects the falling edge of the C̅A̅S̅ signal before the falling edge of the R̅A̅S̅ signal, it sends an internal address driving signal (ADI) to the driver of the refresh address buffer and enables that driver. Therefore, a refresh address is sent out from the driver of the refresh address buffer to the address decoder, and refreshing of data stored in a memory cell is effected.

After such reacting/writing or refreshing operations the C̅A̅S̅ before R̅A̅S̅ detector is reset by a rising edge of the R̅A̅S̅ signal, and the external and internal address driving signals (ADE and ADI) are set to low level. This disables the drivers of the external and refresh address buffers and the circuit returns to a stand-by state.

By the employment of such a configuration in an embodiment of the present invention sequential processing for sending out a refresh signal, switching from external to refresh address, and enabling address buffer, which has accounted for a major part of refreshing time, is eliminated. Set-up time is considerably reduced. Moreover, since the preamplifiers of the external and the refresh address buffers are enabled in advance, as it were, by the falling edge of the R̅A̅S̅ signal, they are already in a stand-by state before an external or internal address driving signal (ADE or ADI) signal is sent out to them from the C̅A̅S̅ before R̅A̅S̅ detector. So, as soon as an external or internal address driving signal is sent out, the driver of the external or refresh address buffer sends out the corresponding address signal to the address decoder. The build-up time of the drivers becomes much shorter than that of ordinary address buffers; therefore, the set-up time is further reduced.

Therefore, with the refresh circuitry of an embodiment of the present invention, it is unnecessary to advance the falling edge of the C̅A̅S̅ signal so much as compared with the previously proposed arrangement of Fig. 1. In practice, an advance that is equivalent to the delay time of only one gate is sufficient for refresh cycle control. So, set-up time is reduced to a greater extent.

Reference is made, by way of example, to the accompanying drawings, in which:-
Fig. 1 is a schematic block diagram illustrating circuit configuration of a previously proposed semiconductor dynamic memory device;
Fig. 2 is a time chart, illustrating operational timing relationships in relation to the device of Fig. 1;
Fig. 3 is a schematic block diagram illustrating circuit configuration of a main part of a dynamic memory embodying the present invention;
Fig. 4 is a time chart, illustrating operational timing relationships between various parts of the circuit of Fig. 3;
Fig. 5 is a schematic circuit diagram showing main parts of a C̅A̅S̅ before R̅A̅S̅ detector employed in an embodiment of the present invention; and
Fig. 6 is a schematic circuit diagram showing main parts of an address buffer employed in an embodiment of the present invention.

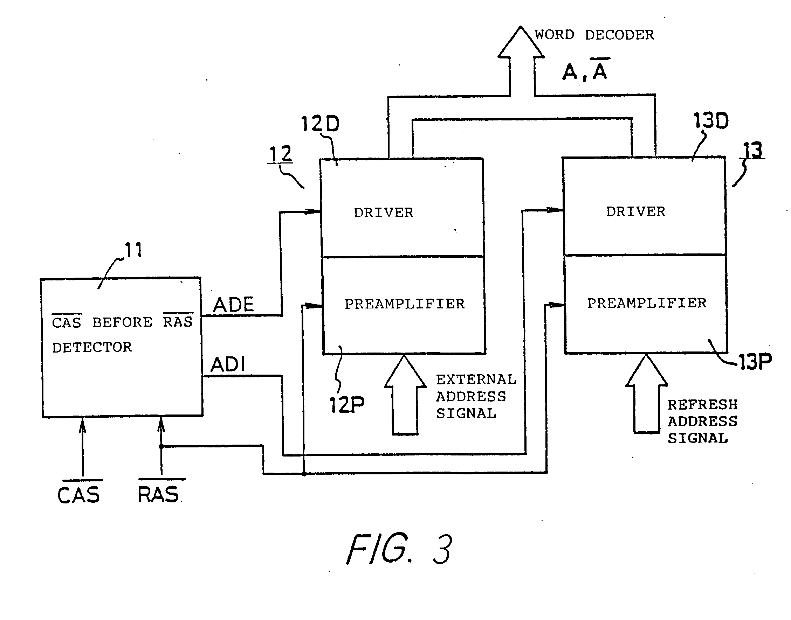

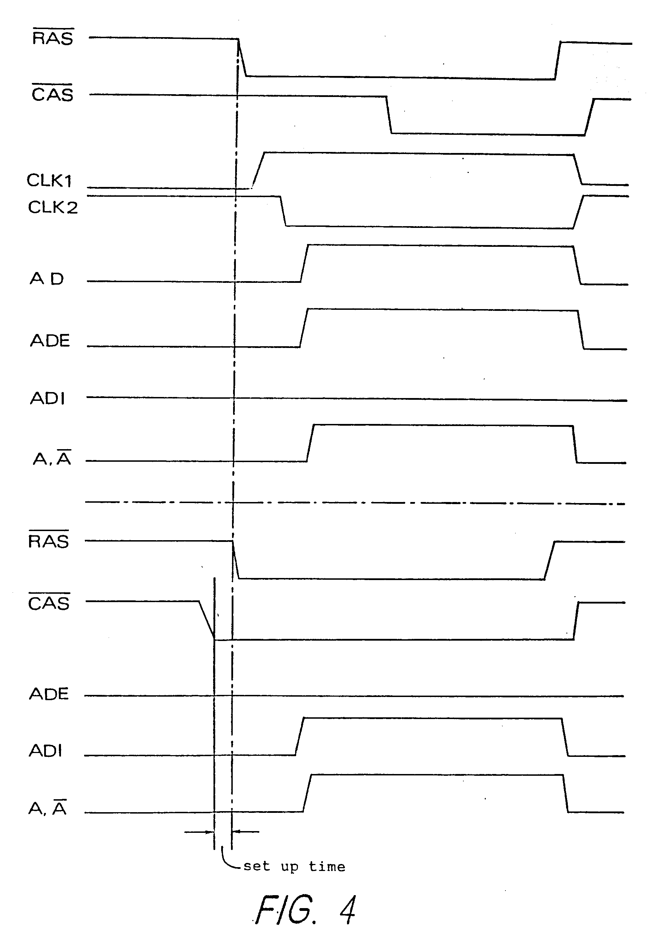

Fig. 3 illustrates schematically the circuit confifiguration of main parts of a dynamic memory device embodying the present invention, and Fig. 4 illustrates operational timings in relation to various parts of the device. Compared to the previously proposed device of Fig. 1, the dynamic memory device embodying the present invention is provided with two address buffer memories 12 and 13. The address buffer memory 12 is used exclusively for external address signals and is called the external address buffer. The buffer memory 13 is used exclusively for refresh address signals and is called the refresh address buffer.

The external address buffer 12 and refresh address buffer 13 are each composed of a preamplifier (12P and 13P respectively) and a driver (12D and 13D respectively). To the preamplifier 12P is supplied an external address signal from an external circuit. To the preamplifier 13P is supplied a refresh address signal generated by a refresh address counter (not shown, but similar to such used in the previously proposed dynamic memory device).

The preamplifiers 12P and 13P are also supplied with the R̅A̅S̅ signal. When the R̅A̅S̅ signal becomes low level, these preamplifiers are enabled and amplify their respective input signals, for example to the level of their source voltages. The drivers 12D and 13D are still disabled at this time, so no output signal appears from the external address buffer 12 or refresh buffer 13.

In Fig. 3, 11 is a C̅A̅S̅ before R̅A̅S̅ detector 11 which detects the falling edges of the C̅A̅S̅ and R̅A̅S̅ signals applied to the memory device from external circuits. In normal operation, the dynamic memory device is sending out stored data to an external circuit or receiving data from an external circuit to rewrite data stored in the device with a new data. However, at a time of refreshing, the dynamic memory device refreshes its stored data.

During normal operation, the external circuit sends a C̅A̅S̅ signal which reaches a low level L after the R̅A̅S̅ signal has reached a low level L, as shown in Fig. 4.

In Fig. 4, the portion of the Figure above the chain line gives time relationships relating to normal operation, whilst the portion below the chain line gives time relationships relating to refresh operation.

In normal operation, the C̅A̅S̅ before R̅A̅S̅ detector 11 discriminates the time difference between the falling edges of the C̅A̅S̅ and R̅A̅S̅ signals, and sends an external address driving signal ADE to driver 12D of the external address buffer 12, and enables that driver. So, an external address signal is amplified so as to have enough power to drive following circuits and is sent to the word decoder (not shown) as an A and A̅ signal as shown in Fig. 3. Following operations are similar to those of the previously proposed device described with reference to Figs. 1 and 2, so, further description is omitted for the sake of simplicity.

As shown in Fig. 4, when the R̅A̅S̅ signal becomes high level H, the ADE signal is reset to low level, and the circuitry is placed in a stand-by state.

When it comes to refreshing, the falling edge of the C̅A̅S̅ signal is advanced so that the C̅A̅S̅ signal falls to an L level a little before the R̅A̅S̅ signal falls to an L level. Such control of the C̅A̅S̅ signal is effected by external circuitry using a delay circuit or by varying counting rate of a clock pulse. As shown in Fig. 4, the advancement of the falling edge of the C̅A̅S̅ signal may be very slight as compared to the advancement required for the previously proposed device. The Figure shows the advancement of the C̅A̅S̅ signal rather exaggeratedly: it may be sufficient for it to be 1-2 n.sec.

The C̅A̅S̅ before R̅A̅S̅ detector 11 discriminates the advancement of the falling edge of the C̅A̅S̅ signal, and it sends an internal address driving signal ADI to the driver 13D of the refresh address buffer 13. So, a refresh address signal is sent out to the word decoder (not shown) as an A and A̅ signal as shown in Fig. 3, and refreshing of stored data is effected. When the R̅A̅S̅ signal becomes high level, the ADI signal is reset to a low level and the circuitry is placed in a stand-by state.

As can be seen from the above description, the total operation of the dynamic memory device embodying the present invention is very simple. Of importance is the discrimination of whether the C̅A̅S̅ signal is H or L level when the R̅A̅S̅ signal becomes L level.

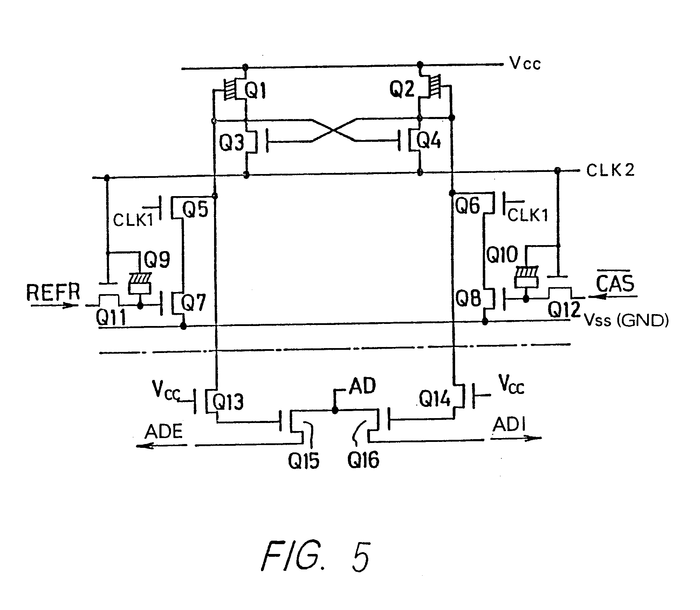

Fig. 5 is a circuit diagram illustrating main features of a C̅A̅S̅ before R̅A̅S̅ detector which can be used in an embodiment of the present invention.

In Fig. 5, the portion of the Figure above the horizontal chain line corresponds to a preamplifier, while the portion below the chain line corresponds to an output stage of the C̅A̅S̅ before R̅A̅S̅ detector
Q1 to Q16 are transistors, those shown with hatching (Q1, G2, Q9 and Q10) being depletion-type FETs (field effect transistor) and the rest being enhancement-type FETs. The FETs Q3 and Q4 form a flip flop circuit, and Q1 and Q2 operate as load resistors. Source and drain of the FETs Q9 and Q10 are respectively connected to each other. Vcc and Vss are, respectively, positive and negative voltage source. Usually, Vss is ground. The C̅A̅S̅ signal is supplied to Q12, and a reference voltage REFR is supplied to Q11.

The circuit is controlled by two control signals CLK1, CLK2 and an address driving signal AD. These control signals are generated generally coincidentally with the falling edge of the R̅A̅S̅ signal. However, as can be seen in Fig. 4, the falling edge of the second control signal CLK2 is delayed a little behind that of CLK1, and the rising edge of address driving signal AD is further delayed. The control signal CLK1 is supplied to the gates of Q5 and Q6. Sources of Q3 and Q4, and gates of Q9, Q10, Q11 and Q12 are connected to each other and supplied with a second driving signal (the second control signal CLK2). Address driving signal AD is fed to Q15 and Q16 as shown in Fig. 5. Generation of such signals and their timings are controlled by means of clock pulses provided using conventional circuits. Such circuits are common in the art, so further description is omitted for the sake of simplicity.

Operation of the detector of Fig. 5 is as follows.

First, in a stand-by state, CLK1 is at low level and CLK2 is at high level as shown in the time chart of Fig. 4. So the C̅A̅S̅ signal and a reference voltage REFR are respectively supplied to Q12 and Q11 via Q10 and Q9 respectively. However, since the gates of Q5 and Q6 are at low level, Q5 and Q6 are cut off so the circuit is still disabled. When the falling edge of the R̅A̅S̅ signal is detected, the control signal CLK1 becomes H, and the circuit is enabled, but since CLK2 is still at high level, operation of the flip flop circuit Q3 and Q4 is suppressed.

The C̅A̅S̅ signal is compared with reference voltage REFR and it is determined whether C̅A̅S̅ is at H or L level. The reference voltage REFR is 1.5 volt for example. When the CLK2 signal becomes L level, the flip flop circuit of Q3 and Q4 discriminates a voltage difference between the C̅A̅S̅ signal and REFR, and charges up the gate of one of Q15 and Q16 to H level, and discharges the gate of the other to L level according to the direction of voltage difference. At the same time, Q9 and Q10 are cut off. So, charges in the gates of Q7 and Q8 are clamped there. This protects Q7 and Q8 from malfunction caused by fluctuation of circuit voltages. Such a circuit is well known in the art, so further description is omitted.

If the C̅A̅S̅ signal is lower than the reference voltage, that is if the C̅A̅S̅ signal is at L level, current running through Q7 is larger than that through Q8. This voltage difference is detected by the flip flop circuit of Q3 and Q4. So, the gate of Q15 receives L level and the gate of Q16 receives H level. At this time if the address driving signal AD is supplied to the drains of Q15 and Q16, a signal will appear from the source of Q16, indicating that C̅A̅S̅ was already L level when the R̅A̅S̅ signal reached L level. This means that C̅A̅S̅ has reached L level before R̅A̅S̅ so the signal from Q16 is an ADI signal (internal address driving signal). It will be clear that if C̅A̅S̅ signal is higher than REFR, an ADE signal (external address driving signal) is delivered from Q15. The ADE and ADI signals are supplied respectively to the drivers 12D and 13D as shown in Fig. 3.

When the R̅A̅S̅ signal becomes H level, CLK1 is pulled down to L level, and CLK2 is pulled up to H level and the circuit returns to the stand-by state.

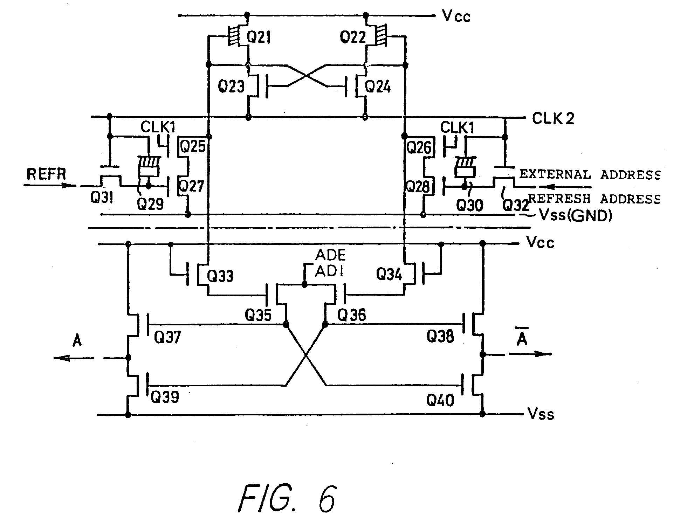

Fig. 6 is a circuit diagram of an address buffer which can be used for both the external address buffer 12 and the refresh address buffer 13 shown in Fig. 4.

That portion of Fig. 6 above the horizontal chain line corresponds to the preamplifier 12P or 13P, and that portion below the horizontal chain line corresponds to the driver 12D or 13D.

In Fig. 6, Q21 to Q40 are FETs, those which are hatched being depletion-type FETs and the others being enhancement-type FETs. Items similar to those in Fig. 5 are designated by similar reference signs. It will be apparent that the circuit in Fig. 6 above the horizontal chain line is very similar to the upper part of Fig. 5, except that the C̅A̅S̅ signal is replaced by an external address signal or a refresh address signal. In the lower part of Fig. 6, as compared with Fig. 5, the AD signal is replaced by the address driving signals ADE or ADI and other differences are apparent. The circuit of Fig. 6 is controlled by CLK1 and CLK2 signals, in a similar manner to that described with reference to Fig. 5. Therefore, as will be clear, when CLK1 and CLK2 are at H level an address signal and its reverse or complement will appear from the sources of Q35 and Q36. Compared with the circuit of Fig. 5, the output circuit of the Fig. 6 comprises transistors Q37 - Q39 and Q38 - Q40. So, if an ADE or an ADI signal is applied to the drains of Q35 and Q36, A or A̅ address signals are sent out to the address decoder.

As will be clear from the above explanation, the C̅A̅S̅ before R̅A̅S̅ detector 11 and the preamplifiers of the address buffers 12, 13 are enabled at the same time by the falling edge of the R̅A̅S̅ signal. So they begin to operate in parallel with each other. This contrasts with the sequential operation of the previously proposed circuit, and is a significant factor in improving set-up time. While the C̅A̅S̅ before R̅A̅S̅ detector is discriminating the timing of falling edges, a preamplifier, 12P or 13P, amplifies an address signal, and an output driver circuit, 12D or 13D, is set ready to send out the signals. As soon as the AD signal arrives, the driver sends out the address signal to the word decoder.

In one embodiment of the present invention, the set-up time of a dynamic memory device has been reduced to approximately 1-2 n.sec. compared to 23-30 n.sec. for the previously proposed device. So, the cycle time of a computer or data processor using such dynamic memory devices can be reduced to a significant extent.

A semiconductor dynamic memory device embodying the present invention can offer improved refreshing time. The memory device has two buffer memories used respectively and exclusively for external and refresh addresses. Each of these buffer memories has a preamplifier and a driver stage. When the falling edge of the R̅A̅S̅ signal is detected, all these circuitries are enabled in parallel, but the operation of the driver stages is suppressed. As soon as the C̅A̅S̅ before R̅A̅S̅ detector discriminates which of the falling edges of the C̅A̅S̅ and R̅A̅S̅ signals achieved a low state earlier, it sends an address driving signal to one of the driver stages, and an external address or a refresh address is sent out immediately. In this way, sequential operations for discriminating the falling edges of R̅A̅S̅ and C̅A̅S̅ signals, sending out a refresh signal, receiving that signal and switching a circuit from external address to refresh address are eliminated, and replaced by parallel operations. Set-up time of a dynamicic memory has wasted approximately 20-30 n.sec. in previously proposed devices, and has occupied a major portion of refreshing cycle time. In an embodiment of the present invention, set-up time has been reduced to 1-2 n.sec.

## Claims

1. A semiconductor dynamic memory device, read/write and refreshing operations of which are controlled in dependence upon R̅A̅S̅ and C̅A̅S̅ signals supplied from external circuitry, comprising:-
a memory cell array (8) for storing data;
a word decoder (7) for decoding address signals supplied thereto and for selecting word lines of the memory array; and
a refresh address counter (4) for generating refresh address signals;
characterised in that the memory device further comprises:-
a C̅A̅S̅ before R̅A̅S̅ detector 11, operable to detect falling edges of the C̅A̅S̅ and R̅A̅S̅ signals applied to the memory device, and to provide an external address driving signal (ADE) when it detects that a falling edge of the R̅A̅S̅ signal precedes a falling edge of the C̅A̅S̅ signal, and to provide a refresh address driving signal (ADI) when it detects that a falling edge of the C̅A̅S̅ signal precedes a falling edge of the R̅A̅S̅ signal;
external address buffer means (12) for latching, in response to a falling edge of the R̅A̅S̅ signal, an external address sent to the dynamic memory device from an external circuit, and for sending that address to said word decoder (7) when said external address buffer means receives said external address driving signal (ADE); and
refresh address buffer means (13) for latching, in response to a falling edge of the R̅A̅S̅ signal, a refresh address generated by the refresh address counter (4) and sending that refresh address to said word decoder (7) when said refresh address buffer means receives said refresh address driving signal (ADI).

2. A device as claimed in claim 1, wherein the external address buffer means (12) comprises:-
a first preamplifier (12P), for amplifying an external address signal applied to the memory device; and first driver means (12D), for sending out the external address signal as amplified by said first preamplifier to the word decoder (7) when said first driver means receives an external address driving signal (ADE).

3. A device as claimed in claim 1 or 2, wherein said refresh address buffer means (13) comprises:
a second preamplifier (13P),for amplifying a refresh address signal generated by said refresh address counter (4); and
second driver means (13D),for sending out the refresh address signal as amplified by said second preamplifier to the word decoder (7) when said second driver receives a refresh address driving signal (ADI).

4. A device as claimed in claim 1, 2 or 3, wherein said external address buffer means (12) and said refresh address buffer means (13) are operable to be reset when the R̅A̅S̅ signal reaches a high level.

5. A device as claimed in any preceding claim, wherein said C̅A̅S̅ before R̅A̅S̅ detector comprises:
first generating means, for generating a first control signal (CLK1) which becomes high level when said R̅A̅S̅ signal becomes low level, and becomes low level when said R̅A̅S̅ signal becomes high level;
second generating means, for generating a second control signal (CLK2) which becomes low level after said first control signal (CLK1) signal becomes high level, and becomes high level when said R̅A̅S̅ signal becomes high level; and
third generating means, for generating a control address driving signal (AD) which becomes high level after said second control signal (CLK2) signal becomes low level, and becomes low level when said R̅A̅S̅ signal becomes high level.

6. A device as claimed in claim 5, wherein said C̅A̅S̅ before R̅A̅S̅ detector comprises
a preamplifier stage which is enabled when the first control signal (CLK1) becomes high level, and discriminates a voltage difference between the C̅A̅S̅ signal and a predetermined reference voltage (REFR) when the second control signal (CLK2) becomes low level; and
output means for generating either an external address driving signal (ADE) or a refresh address driving signal (ADI) when it receives the control address driving signal (AD), the output means generating the external address driving signal (ADE) when said preamplifier stage of the detector discriminates that the C̅A̅S̅ signal is higher than the reference voltage (REFR), and generating the refresh address driving signal (ADI) when the preamplifier stage of the detector discriminates that the C̅A̅S̅ signal is lower than the reference voltage (REFR) when the R̅A̅S̅ signal becomes low level.

7. A device as claimed in 5 or 6 when read as appended to claim 2, wherein,
said first preamplifier (12P) is enabled when the first control signal (CLK1) becomes high level, and discriminates a voltage difference between an external address signal supplied thereto and a predetermined reference voltage (REFR) when the second control signal becomes low level, and said first preamplifier (12P) is reset when the R̅A̅S̅ signal becomes high level.

8. A device as claimed in claim 5, 6 or 7 when read as appended to claim 3, wherein,
said second preamplifier (13D) is enabled when the first control signal (CLK1) becomes high level, and discriminates a voltage difference between refresh address signal supplied thereto and a predetermined reference voltage (REFR) when the second control signal becomes low level, and said second preamplifier (13D) is reset when said R̅A̅S̅ signal becomes high level.

## Patentansprüche

1. Dynamische Halbleiterspeicheranordnung, deren Lese-/Schreib- und Refresh-Operationen in Abhängigkeit von R̅A̅S̅- und C̅A̅S̅-Signalen, welche von einer externen Schaltung zugeführt werden, gesteuert werden, umfassend:
eine Speicherzellenmatrix (8) zum Speichern von Daten;
einen Wortdecodierer (7) zum Decodieren von Adressensignalen, welche ihm zugeführt werden, und zum Auswählen von Wortzeilen der Speichermatrix; und
einen Refresh-Adressenzähler (4) zum Erzeugen von Refresh-Adressensignalen, gekennzeichnet dadurch, daß der Speicher weiter umfaßt:
einen C̅A̅S̅-vor-R̅A̅S̅-Detektor (11), welcher betriebsfähig ist, um abfallende Flanken von C̅A̅S̅- und R̅A̅S̅-Signalen, welche dem Speicher zugeführt werden, zu erkennen und ein Treibersignal für eine externe Adresse (ADE) zu liefern, wenn er erkennt, daß eine abfallende Flanke eines R̅A̅S̅-Signals einer abfallenden Flanke des C̅A̅S̅-Signals vorangeht, und um ein Treibersignal für eine Refresh-Adresse (ADI) zu liefern, wenn er erkennt, daß eine abfallende Flanke des C̅A̅S̅-Signals einer abfallenden Flanke des R̅A̅S̅-Signals vorangeht;
einen externen Adressenpuffer (12) zum Halten, als Reaktion auf eine abfallende Flanke des R̅A̅S̅-Signals, einer externen Adresse, welche dem dynamischen Speicher von einer externen Schaltung gesendet wurde, und zum Senden dieser Adresse an den Wortdecodierer (7), wenn der externe Adressenpuffer das Treibersignal für die externe Adresse (ADE) empfängt; und
einen Refresh-Adressenpuffer (13) zum Halten, als Reaktion auf eine abfallende Flanke des R̅A̅S̅-Signals, einer Refresh-Adresse, welche von einem Refresh-Adressenzähler (4) erzeugt wurde, und Senden dieser Refresh-Adresse zum Wortdecodierer (7), wenn der Refresh-Adressenpuffer das Treibersignal für die Refresh-Adresse (ADI) empfängt.

2. Anordnung wie in Anspruch 1 beansprucht, worin der externe Adressenpuffer (12) umfaßt:
einen ersten Vorverstärker (12P) zum Verstärken eines externen Adressensignals, welches dem Speicher zugeführt wurde; und
einen ersten Treiber (12D) zum Aussenden des externen Adressensignals, wie es durch den ersten Vorverstärker verstärkt wurde, an den Wortdecodierer (7), wenn der erste Treiber ein Treibersignal für eine externe Adresse (ADE) empfängt.

3. Anordnung wie in Anspruch 1 oder 2 beansprucht, worin der Refresh-Adressenpuffer (13) umfaßt:
einen zweiten Vorverstärker (13P) zum Verstärken eines Refresh-Adressensignals, welches durch den Refresh-Adressenzähler (4) erzeugt wurde; und
einen zweiten Treiber (13D) zum Aussenden des Refresh-Adressensignals, wie es durch den zweiten Vorverstärker verstärkt wurde, an den Wortdecodierer (7), wenn der zweite Treiber ein Treibersignal für eine Refresh-Adresse (ADI) empfängt.

4. Anordnung wie in Anspruch 1, 2 oder 3 beansprucht, worin der externe Adressenpuffer (12) und der Refresh-Adressenpuffer (13) derart betriebsfähig sind, daß sie rückgesetzt werden, wenn das R̅A̅S̅-Signal einen hohen Pegel erreicht.

5. Anordnung wie in irgendeinem vorhergehenden Anspruch beansprucht, worin der C̅A̅S̅-vor-R̅A̅S̅-Detektor umfaßt:
ein erstes Erzeugungsmittel zum Erzeugen eines ersten Steuersignals (CLK1), welches einen hohen Pegel annimmt, wenn das R̅A̅S̅-Signal einen niedrigen Pegel annimmt, und einen niedrigen Pegel annimmt, wenn das R̅A̅S̅-Signal einen hohen Pegel annimmt;
ein zweites Erzeugungsmittel zum Erzeugen eines zweiten Steuersignals (CLK2), welches einen niedrigen Pegel annimmt, nachdem das erste Steuersignal (CLK1) einen hohen Pegel annimmt, und welches einen hohen Pegel annimmt, wenn das R̅A̅S̅-Signal einen hohen Pegel annimmt; und
ein drittes Erzeugungsmittel zum Erzeugen eines Steueradressen-Treibersignals (AD), welches einen hohen Pegel annimmt, nachdem das zweite Steuersignal (CLK2) einen niedrigen Pegel annimmt, und welches einen niedrigen Pegel annimmt, wenn das R̅A̅S̅-Signal einen hohen Pegel annimmt.

6. Anordnung wie in Anspruch 5 beansprucht, worin der C̅A̅S̅-vor-R̅A̅S̅-Detektor umfaßt:
eine Vorverstärkerstufe, welche freigegeben wird, wenn das erste Steuersignal (CLK1) einen hohen Pegel annimmt, und welche eine Spannungsdifferenz zwischen dem C̅A̅S̅-Signal und einer vorbestimmten Referenzspannung (REFR) unterscheidet, wenn das zweite Steuersignal (CLK2) einen niedrigen Pegel annimmt; und
ein Output-Mittel zum Erzeugen entweder eines Treibersignals (ADE) für eine externe Adresse oder eines Treibersignals (ADI) für eine Refresh-Adresse, wenn es das Treibersignal (AD) für eine Steueradresse empfängt, wobei das Output-Mittel das Treibersignal (ADE) für die externe Adresse erzeugt, wenn die Vorverstärkerstufe des Detektors unterscheidet, daß das C̅A̅S̅-Signal höher ist als die Referenzspannung (REFR), und wobei es ein Treibersignal (ADI) für eine Refresh-Adresse erzeugt, wenn die Vorverstärkerstufe des Detektors unterscheidet, daß das C̅A̅S̅-Signal niedriger ist als die Referenzspannung (REFR), wenn das R̅A̅S̅-Signal einen niedrigen Pegel annimmt.

7. Anordnung wie in Anspruch 5 oder 6 beansprucht, wenn er als an Anspruch 2 angehörig gelesen wird, worin
der erste Vorverstärker (12P) freigegeben wird, wenn das erste Steuersignal (CLK1) einen hohen Pegel annimmt, und eine Spannungsdifferenz zwischen einem externen Adressensignal, welches ihm zugeführt wird, und einer vorbestimmten Referenzsspannung (REFR) unterscheidet, wenn das zweite Steuersignal einen niedrigen Pegel annimmt, und der erste Vorverstärker (12P) rückgesetzt wird, wenn das R̅A̅S̅-Signal einen hohen Pegel annimmt.

8. Anordnung wie in Anspruch 5, 6 oder 7 beansprucht, wenn er als an Anspruch 3 angehörig gelesen wird, worin
der zweite Vorverstärker (13D) freigegeben wird, wenn das erste Steuersignal (CLK1) einen hohen Pegel annimmt, und eine Spannungsdifferenz zwischen einem Refresh-Adressensignal, welches ihm zugeführt wird, und einer vorbestimmten Referenzspannung (REFR) unterscheidet, wenn das zweite Steuersignal einen niedrigen Pegel annimmt, und der zweite Vorverstärker (13D) rückgestellt wird, wenn das RAS-Signal einen hohen Pegel annimmt.

## Revendications

1. Dispositif de mémoire dynamique à semiconducteur dont les opérations de lecture/écriture et de rafraîchissement sont commandées selon des signaux R̅A̅S̅ et C̅A̅S̅ fournis par des circuits externes, comprenant:
une matrice de cellules de mémoire (8) pour mémoriser des données;
un décodeur de mot (7) pour décoder des signaux d'adresse qui lui sont fournis et pour sélectionner des fils de mot de la matrice de mémoire; et
un compteur d'adresse de rafraîchissement (4) pour engendrer des signaux d'adresse de rafraîchissement;
caractérisé en ce que le dispositif de mémoire comprend en outre:
un détecteur de C̅A̅S̅ avant R̅A̅S̅ (11), pouvant être mis en fonctionnement pour détecter les fronts descendants des signaux C̅A̅S̅ et R̅A̅S̅ appliqués au dispositif de mémoire, et pour fournir un signal de commande d'adresse externe (ADE) quand il détecte qu'un front descendant du signal R̅A̅S̅ précède un front descendant du signal C̅A̅S̅, et pour fournir un signal de commande d'adresse de rafraîchissement (ADI) quand il détecte qu'un front descendant du signal C̅A̅S̅ précède un front descendant du signal R̅A̅S̅;
un moyen à tampon d'adresse externe (12) pour verrouiller, en réponse à un front descendant du signal R̅A̅S̅, une adresse externe envoyée au dispositif de mémoire dynamique par un circuit externe, et pour envoyer cette adresse audit décodeur de mot (7) quand ledit moyen à tampon d'adresse externe reçoit ledit signal de commande d'adresse externe (ADE); et
un moyen à tampon d'adresse de rafraîchissement(13) pour verrouiller, en réponse à un front descendant du signal R̅A̅S̅, une adresse de rafraîchissement générée par le compteur d'adresse de rafraîchissement (4) et pour envoyer cette adresse de rafraîchissement audit décodeur de mot (7) quand ledit moyen à tampon d'adresse de rafraîchissement reçoit ledit signal de commande d'adresse de rafraîchissement (ADI).

2. Dispositif selon la revendication 1, dans lequel le moyen à tampon d'adresse externe (12) comprend:
un premier préamplificateur (12P), pour amplifier un signal d'adresse externe appliqué au dispositif de mémoire; et
un premier moyen de commande (12D), pour envoyer le signal d'adresse externe tel qu'amplifié par ledit premier préamplificateur au décodeur de mot (7) quand ledit premier moyen de commande reçoit un signal de commande d'adresse externe (ADE).

3. Dispositif selon l'une quelconque des revendications 1 et 2, dans lequel ledit moyen à tampon d'adresse de rafraîchissement (13) comprend:
un second préamplificateur (13P), pour amplifier un signal d'adresse de rafraîchissement engendré par ledit compteur d'adresse de rafraîchissement (4); et
un second moyen de commande (13D), pour envoyer le signal d'adresse de rafraîchissement tel qu'amplifié par ledit second préamplificateur au décodeur de mot (7) quand ledit second moyen de commande reçoit un signal de commande d'adresse de rafraichissement (ADI).

4. Dispositif selon l'une quelconque des revendications 1 à 3, dans lequel ledit moyen à tampon d'adresse externe (12) et ledit moyen à tampon d'adresse de rafraîchissement (13) peuvent être mis en fonctionnement pour être remis à l'état initial quand le signal R̅A̅S̅ atteint un niveau haut.

5. Dispositif selon l'une quelconque des revendications 1 à 4, dans lequel ledit détecteur de C̅A̅S̅ avant R̅A̅S̅ comprend:
un premier moyen générateur, pour engendrer un premier signal de commande (CLK1) qui passe au niveau haut quand ledit signal R̅A̅S̅ passe au niveau bas, et passe au niveau bas quand ledit signal R̅A̅S̅ passe au niveau haut;
un deuxième moyen générateur, pour engendrer un second signal de commande (CLK2) qui passe au niveau bas après que ledit premier signal de commande (CLK1) soit passé au niveau haut, et passe au niveau haut quand ledit signal R̅A̅S̅ passe au niveau haut; et
un troisième moyen générateur , pour engendrer un signal de commande d'adresse de commande (AD) qui passe au niveau haut après que ledit second signal de commande (CLK2) soit passé au niveau bas, et passe au niveau bas quand ledit signal R̅A̅S̅ passe au niveau haut.

6. Dispositif selon la revendication 5, dans lequel ledit détecteur de C̅A̅S̅ avant R̅A̅S̅ comprend:
un étage préamplificateur qui est validé quand le premier signal de commande (CLK1) passe au niveau haut, et discrimine la différence de tension entre le signal C̅A̅S̅ et une tension de référence prédéterminée (REFR) quand le second signal de commande (CLK2) passe au niveau bas; et
un moyen de sortie pour engendrer soit un signal de commande d'adresse externe (ADE), soit un signal de commande d'adresse de rafraîchissement (ADI) quand il reçoit le signal de commande d'adresse de commande (AD), le moyen de sortie générant le signal de commande d'adresse externe (ADE) quand ledit étage préamplificateur du détecteur détecte par discrimination que le signal C̅A̅S̅ est supérieur à la tension de référence (REFR), et générant le signal de commande d'adresse de rafraîchissement (ADI) quand l'étage préamplificateur du détecteur détecte par discrimination que le signal C̅A̅S̅ est inférieur à la tension de référence (REFR) quand le signal R̅A̅S̅ passe au niveau bas.

7. Dispositif selon l'une quelconque des revendications 5 et 6 telles que rattachées à la revendication 2, dans lequel,
ledit premier préamplificateur (12P) est validé quand le premier signal de commande (CLK1) passe au niveau haut, et discrimine la différence de tension entre un signal d'adresse externe qui lui est fourni et une tension de référence prédéterminée (REFR) quand le second signal de commande passe au niveau bas, et ledit premier préamplificateur (12P) est remis à l'état initial quand le signal R̅A̅S̅ passe au niveau haut.

8. Dispositif selon l'une quelconque des revendications 5 à 7 telles que rattachées à la revendication 3, dans lequel,
ledit second préamplificateur (13D) est validé quand le premier signal de commande (CLK1) passe au niveau haut, et discrimine la différence de tension entre le signal d'adresse de rafraîchissement qui lui est fourni et une tension de référence prédéterminée (REFR) quand le second signal de commande passe au niveau bas, et ledit second préamplificateur (13D) est remis à l'état initial quand ledit signal R̅A̅S̅ passe au niveau haut.
